(19) Europäisches Patentamt
European Patent Office
Office européen des brevets

(11) Veröffentlichungsnummer: **0 224 162**
**B1**

# (12) EUROPÄISCHE PATENTSCHRIFT

(45) Veröffentlichungstag der Patentschrift: **29.08.90**

(51) Int. Cl.[5]: **G03F 7/021**

(21) Anmeldenummer: **86115913.5**

(22) Anmeldetag: **17.11.86**

(54) **Lichtempfindliches, Diazoniumgruppen enthaltendes Polykondensationsprodukt, Verfahren zu seiner Herstellung und lichtempfindliches Aufzeichnungsmaterial, das dieses Polykondensationsprodukt enthält.**

(30) Priorität: **26.11.85 DE 3541723**

(43) Veröffentlichungstag der Anmeldung: **03.06.87 Patentblatt 87/23**

(45) Bekanntmachung des Hinweises auf die Patenterteilung: **29.08.90 Patentblatt 90/35**

(84) Benannte Vertragsstaaten: **DE FR GB**

(56) Entgegenhaltungen: **US-A-3 219 447**

(73) Patentinhaber: **HOECHST AKTIENGESELLSCHAFT, Postfach 80 03 20, D-6230 Frankfurt am Main 80(DE)**

(72) Erfinder: **Franke, Werner, Dr., Dipl.-Chem., Wendelsteinstrasse 58, D-6200 Wiesbaden(DE)**
Erfinder: **Brahm, Richard, Im Blumengarten 33, D-6507 Ingelheim(DE)**

EP 0 224 162 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft neue lichtempfindliche Polykondensationsprodukte aromatischer Diazoniumsalze, die zur Herstellung von mit Wasser entwickelbaren lichtempfindlichen Aufzeichnungsmaterialien, insbesondere für die Herstellung von Flachdruckplatten, geeignet sind.

Es ist bekannt, Polykondensationsprodukte durch Umsetzen von aromatischen Diazoniumsalzen, insbesondere Diphenylamin-4-diazoniumsalzen, mit reaktive Methylolgruppen bzw. deren Ester oder Ether tragenden Zweitkomponenten herzustellen, wobei die reaktiven Gruppen im einfachsten Fall durch Umsetzen der Zweitkomponente mit Formaldehyd eingeführt werden. Diese Kondensationsprodukte liefern hochwertige strahlungsempfindliche Materialien, insbesondere Druckplatten, und werden in großem Umfang technisch genutzt. Sie sind in der US-A 3 849 392 beschrieben.

Alle technisch genutzten Druckplatten auf Basis dieser Kondensationsprodukte werden mit vorwiegend wäßrigen Lösungen entwickelt. Diese Lösungen erfordern jedoch stets weitere Zusätze wie alkalische oder saure Puffersalze, mit Wasser mischbare organische Lösungs- oder Netzmittel in nicht unbeträchtlichen Mengen. Solche Zusätze werden besonders dann erforderlich, wenn die lichtempfindliche Schicht außer den Diazoniumsalz-Polykondensationsprodukten noch polymere Bindemittel enthält. Derartige Platten sind z. B. in den EP-A 48 876 und 71 881 beschrieben.

Es wäre aus Gründen der leichten Verarbeitbarkeit und insbesondere zur Verminderung der Umweltbelastung erwünscht, Flachdruckplatten allein mit Wasser entwickeln zu können.

Es ist zwar aus der DE-B 12 14 086 bekannt, daß man negativ arbeitende Flachdruckplatten auf Basis von Diphenylamin-4-diazoniumsalz-Formaldehyd-Kondensationsprodukten durch Entwickeln mit reinem Wasser erhalten kann. Diese Platten liefern jedoch nur eine relativ niedrige Druckauflage und haben eine verhältnismäßig geringe Lichtempfindlichkeit. Auch ist die Farbannahme dieser Druckformen meist nicht ausreichend, so daß eine zusätzliche Behandlung der entwickelten Platte mit einem oleophilen Lack erforderlich ist.

Aus der DE-A 20 41 395 ist schließlich ein lichtempfindliches Gemisch für die Herstellung von Siebdruckformen bekannt, das ein wasserlösliches Diazoniumsalz-Mischkondensationsprodukt des eingangs beschriebenen Typs enthält, das als Salz einer niederen aliphatischen Monosulfonsäure vorliegt. Diese Kondensationsprodukte sind lichtempfindlicher als die zuvor erwähnten Formaldehyd-Kondensationsprodukte. Sie werden stets in Kombination mit einem hydrophilen Polymeren eingesetzt, sind aber ausschließlich für die Herstellung von Siebdruckschablonen beschrieben und lassen sich mit reinem Wasser entwickeln. Eine Verwendung der Kondensationsprodukte dieser Druckschrift auch für den Flachdruck ist nicht erwähnt; die dort beschriebenen Gemische wären dafür auch wegen ihres hohen Gehalts an hydrophilem Bindemittel ungeeignet.

Wie nun weiter gefunden wurde, neigen diese Diazoniumsalz-Kondensationsprodukte bei der Fällung mit Methansulfonsäure bzw. deren Salzen dazu, eine relativ große Menge an Verunreinigungen mitzureißen. Die Fällungsprodukte müssen deshalb mühevoll gereinigt werden, wenn man Produkte mit reproduzierbarer Zusammensetzung und Aktivität erhalten will. Andere Kondensationsprodukte dieser Art müssen nach dem Ausfällen längere Zeit bei erhöhter Temperatur gerührt werden, bis sie in eine filtrierbare Form übergegangen sind.

Aufgabe der Erfindung war es, ein lichtempfindliches Diazoniumsalz-Kondensationsprodukt vorzuschlagen, das zur Herstellung von Flachdruckplatten hoher Lichtempfindlichkeit und guter Druckauflage geeignet ist und sich nach dem Belichten mit reinem Wasser entwickeln läßt.

Erfindungsgemäß wird ein lichtempfindliches, Diazoniumgruppen enthaltendes Polykondensationsprodukt aus

a) einem Diazoniumsalz der allgemeinen Formel I

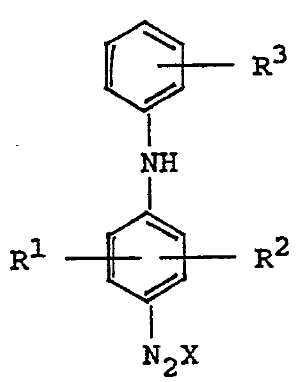

(I)

worin
$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und
X das Anion des Diazoniumsalzes ist, und
b) einer Verbindung der allgemeinen Formel II

$$R^4\text{-O-CH}_2\text{-}R^6\text{-CH}_2\text{-O-}R^5 \qquad \text{(II)}$$

worin
$R^4$ und $R^5$ Wasserstoffatome, Alkylgruppen oder aliphatische Acylreste sind und
$R^6$ der Rest eines aromatischen Kohlenwasserstoffs, eines Phenols, Phenolethers, aromatischen Thioethers, einer aromatischen heterocyclischen Verbindung oder eines organischen Säureamids ist, vorgeschlagen.

Das erfindungsgemäße Kondensationsprodukt ist dadurch gekennzeichnet, daß sein Diazoniumsalzanion das Anion einer Aminoalkansulfonsäure ist.

Erfindungsgemäß wird ferner ein Verfahren zur Herstellung des vorstehend definierten Kondensationsprodukts vorgeschlagen, bei dem man in stark saurem Medium ein Diazoniumsalz der Formel I

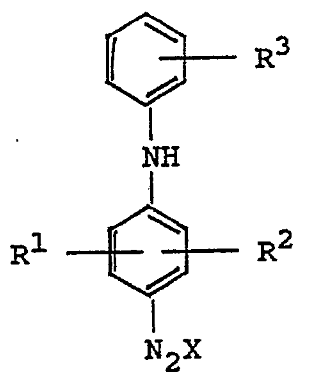

(I)

worin
$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und
X das Anion des Diazoniumsalzes ist,
mit einer Verbindung der Formel II

$$R^4\text{-O-CH}_2\text{-}R^6\text{-CH}_2\text{-O-}R^5 \qquad \text{(II)}$$

kondensiert, worin
$R^4$ und $R^5$ Wasserstoffatome, Alkylgruppen oder aliphatische Acylreste sind und
$R^6$ der Rest eines aromatischen Kohlenwasserstoffs, eines Phenols, Phenolethers, aromatischen Thioethers, einer aromatischen heterocyclischen Verbindung oder eines organischen Säureamids ist.

Das erfindungsgemäße Verfahren ist dadurch gekennzeichnet, daß das erhaltene Kondensationsprodukt durch Zusatz eines Überschusses einer Aminoalkansulfonsäure oder ihres Alkalisalzes als ein Aminoalkansulfonat isoliert wird.

Erfindungsgemäß wird weiterhin ein lichtempfindliches Aufzeichnungsmaterial aus einem Schichtträger und einer lichtempfindlichen Schicht vorgeschlagen, die als lichtempfindliche Verbindung ein Diazoniumsalz-Polykondensationsprodukt enthält.

Das erfindungsgemäße Aufzeichnungsmaterial ist dadurch gekennzeichnet, daß die Schicht ein Polykondensationsprodukt der vorstehend beschriebenen Art enthält.

Die erfindungsgemäßen Kondensationsprodukte werden hergestellt, indem zunächst in bekannter Weise ein Diazoniumsalz der Formel I mit einer Verbindung der Formel II in stark saurem Medium, z. B. in Schwefel-, Phosphor- oder Methansulfonsäure, kondensiert wird. Diese Reaktion ist ausführlich in der US-A 3 849 392 beschrieben. Das Kondensationsprodukt wird aus dem Reaktionsgemisch in üblicher Weise, z. B. als Chlorid, isoliert oder es wird als Rohprodukt weiter verarbeitet. Aus der Lösung des Chlorids in Wasser oder aus dem Reaktionsgemisch wird das gewünschte Salz durch Zusatz einer konzentrierten wäßrigen Lösung der entsprechenden Aminoalkansulfonsäure oder eines Alkalisalzes derselben ausgefällt. Dabei fällt überraschenderweise das Aminoalkansulfonat des Kondensationsprodukts bereits in sehr reiner Form an; es braucht deshalb für die meisten Anwendungszwecke nicht mehr gereinigt zu werden.

Die Ausfällung erfolgt z. B. so, daß einer wäßrigen Lösung des Chlorids des Diazoniumsalz-Polykondensationsprodukts eine konzentrierte wäßrige Lösung der gewünschten Sulfonsäure in mindestens etwa 10 % Überschuß zugesetzt und das Gemisch z. B. bei 20° C eine Zeitlang, etwa 3 Minuten, gerührt wird. Dann wird das Produkt durch Aussalzen mit Natriumchlorid zur Ausfällung gebracht und etwa 20

bis 30 Minuten nachgerührt, bis ein gut absaugfähiger Niederschlag entsteht, der auch beim Trocknen nicht mehr verklebt. Der Niederschlag wird abgesaugt, mit gesättigter Natriumchloridlösung gewaschen und bei ca. 40° C im Vakuum getrocknet.

Geeignete Aminoalkansulfonsäuren sind solche mit 2 bis 12, insbesondere 4 bis 10 Kohlenstoffatomen. Die Aminogruppen können primär, sekundär oder tertiär, insbesondere sekundär oder tertiär sein. Als weitere Substituenten können die Aminoalkansulfonsäuren z. B. Hydroxy- oder Alkoxygruppen oder Halogenatome aufweisen. Die Alkangruppen können ungesättigt oder vorzugsweise gesättigt, gerade oder verzweigt oder zum Ring geschlossen sein. Die Aminogruppen können innerhalb der Kette der Aminoalkangruppen oder als seiten- oder endständige Substituenten angeordnet sein. Sie können auch Bestandteil eines vorzugsweise gesättigten heterocyclischen Rings sein.

Als Diazoniumsalz-Polykondensationsprodukte sind Mischkondensationsprodukte kondensationsfähiger aromatischer Diazoniumsalze, z. B. von Diphenylamin-4-diazoniumsalzen geeignet, die außer den Diazoniumsalzeinheiten noch andere, nicht lichtempfindliche Einheiten enthalten, die von kondensationsfähigen Verbindungen, insbesondere aromatischen Aminen, Phenolen, Thiophenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben.

Die Diazoniumsalzeinheiten leiten sich bevorzugt von Verbindungen der Formel $(R^1\text{-}R^3\text{-})_pR^2\text{-}N_2X$ ab, wobei

X das Anion der Diazoniumverbindung,
p eine ganze Zahl von 1 bis 3,
$R^1$ einen aromatischen Rest mit mindestens einer zur Kondensation mit aktiver Carbonylverbindung befähigten Position,
$R^2$ eine Phenylengruppe,
$R^3$ eine Einfachbindung oder eine der Gruppen:
$-(CH_2)_q-NR^4-$,
$-O-(CH_2)_r-NR^4-$,
$-S-(CH_2)_r-NR^4-$,
$-S-CH_2CO-NR^4-$,
$-O-R^5-O-$,
- O -
- S - oder
$-CO-NR^4-$
bedeuten, worin
q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist.

Die erfindungsgemäßen Diazoniumsalz-Polykondensationsprodukte können für unterschiedliche reprographische Zwecke eingesetzt werden, z. B. für die Herstellung von Druckplatten, Siebdruckformen, Photoresists und Farbprüffolien. Sie sind insbesondere für die Herstellung von lichtempfindlichen Flachdruckplatten geeignet. Zu diesem Zweck wird eine bevorzugt wäßrige Lösung des Kondensationsprodukts auf einen für den Flachdruck geeigneten Schichtträger aufgebracht und getrocknet.

Die Beschichtungslösungen können außer den Kondensationsprodukten übliche Zusätze, wie Farbstoffe, Pigmente, Weichmacher, Netzmittel, Verlaufmittel, Farbindikatoren, photolysierbare Säurespender und Bindemittel, insbesondere wasserlösliche Bindemittel, enthalten. Vorzugsweise sind die lichtempfindlichen Schichten frei von Bindemitteln.

Durch die Erfindung wird es möglich, Kopiermaterialien für die Herstellung von Flachdruckformen durch Beschichtung mit rein wäßrigen Beschichtungslösungen herzustellen. Die belichteten Kopiermaterialien können mit reinem Wasser, d. h. mit Wasser ohne irgendwelche Zusätze, wie organische Lösungsmittel, Alkalien oder Salze, entwickelt werden. Die Lichtempfindlichkeit der erfindungsgemäßen Materialien ist sehr hoch.

Zur Herstellung des lichtempfindlichen Kopiermaterials wird die lichtempfindliche Komponente in Wasser gelöst. Die erhaltene Lösung wird auf einen für den Flachdruck geeigneten Schichtträger aufgebracht und die aufgetragene Lösung getrocknet. Die Beschichtung kann durch Aufschleudern, Sprühen, Tauchen, Antragen mittels Walzen oder mit Hilfe eines Flüssigkeitsfilms erfolgen und richtet sich auch nach den Eigenschaften des zu beschichtenden Materials. Die Beschichtungslösung sollte eine Konzentration im Bereich von etwa 0,5 bis 10,0, vorzugsweise von 1,0 bis 4,0 Gew.-%, haben. Der Schichtauftrag sollte (nach dem Trocknen) bei etwa 0,3 g/m² liegen. Die richtige Konzentration ist im Einzelfall durch einfache Versuche zu ermitteln. Die Trockentemperatur liegt im allgemeinen zwischen 45° C und der Zersetzungstemperatur der Diazoniumverbindung. Die Temperatur hängt im einzelnen von der Art des Trocknungsverfahrens und der Trocknungsdauer ab.

Als Schichtträger sind die verschiedensten Materialien wie Papier, Zink, Magnesium, Aluminium,

Chrom, Kupfer, Messing, Stahl und Mehrmetall- oder Kunststoffolien geeignet. Für die Herstellung von Flachdruckplatten wird vorzugsweise mechanisch, chemisch oder elektrolytisch aufgerauhtes Aluminium verwendet, das vorteilhaft vor der Beschichtung in bekannter Weise mit Silikaten oder Phosphonsäuren, insbesondere Polyvinylphosphonsäure, vorbehandelt worden ist.

Die Belichtung des Kopiermaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen.

Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren.

Die Verarbeitung der Kopiermaterialien bis zur druckbereiten Form geschieht in üblicher Weise. Es wird mit Laser bestrahlt oder unter einer Vorlage belichtet. Während die Schicht an den Stellen, auf die das Licht einwirkt, gehärtet und weitgehend unlöslich wird, werden die unbelichteten löslich bleibenden Teile der Schicht durch Tauchen und/oder berührungsloses Abbrausen mit Wasser ausgewaschen bzw. entfernt. Die so hergestellte Flachdruckform wird nach der Entwicklung ggf. mit fetter Farbe eingefärbt und mit einem Konservierungsmittel wie Gummi arabicum versehen.

Als Entwickler wird reines Wasser, z. B. Leitungswasser, bevorzugt. Es können aber auch kleine Mengen organischer Lösungsmittel, Netzmittel, Salze, Säuren und dgl. zugesetzt werden.

Die folgenden Beispiele erläutern bevorzugte Ausführungsformen der Erfindung.

Beispiel 1

Eine 3 %ige wäßrige Lösung des Kondensationsprodukts aus 1 mol 3-Methoxy-diphenylamin-4-diazoniumsalz und 1 mol 4,4'-Bis-methoxymethyl-diphenylether, isoliert als Salz der 2-(4-Hydroxyethyl-piperazino)-ethansulfonsäure wurde mittels Schleuderbeschichtung auf eine Aluminiumplatte, die elektrolytisch aufgerauht, anodisch oxydiert und mit Polyvinylphosphonsäure vorbehandelt worden war, aufgebracht und getrocknet. Die trockene Schicht hatte ein Gewicht von 0,3 g/m². Es wurde eine sehr lichtempfindliche Druckplatte erhalten, die sich nach bildmäßiger Belichtung durch einfaches Abbrausen mit Leitungswasser problemfrei entwickeln läßt.

Beispiel 2

Eine 3 %ige wäßrige Lösung eines Kondensationsprodukts wie in Beispiel 1, jedoch als Salz der 3-Cyclohexylamino-propansulfonsäure, wurde auf der Schleuder auf mechanisch aufgerauhtes Aluminium, das mit Polyvinylphosphonsäure vorbehandelt war, aufgebracht. Nach bildmäßiger Belichtung konnte die Platte mit Wasser entwickelt werden.

Beispiel 3

Eine 3 %ige wäßrige Lösung eines Kondensationsprodukts wie in Beispiel 1, aber als Salz der 3-(Trishydroxymethyl-methylamino)-2-hydroxy-propansulfonsäure, wurde auf trocken gebürstetes Aluminium (mit Polyvinylphosphonsäure vorbehandelt) aufgebracht und getrocknet. Die Platten hatten eine Schichtdicke von 0,4 g/m², waren ausgezeichnet lichtempfindlich und ließen sich nach bildmäßiger Belichtung mit Wasser entwickeln.

**Patentansprüche**

1. Lichtempfindliches, Diazoniumgruppen enthaltendes Polykondensationsprodukt aus

a) einem Diazoniumsalz der allgemeinen Formel I

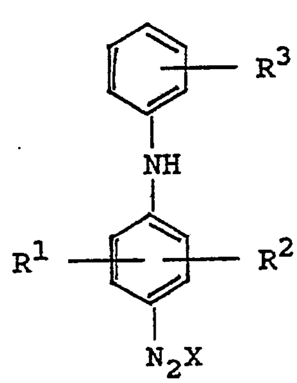

(I)

worin
$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und
X das Anion des Diazoniumsalzes ist, und
b) einer Verbindung der allgemeinen Formel II

$$R^4\text{-O-CH}_2\text{-R}^6\text{-CH}_2\text{-O-R}^5 \qquad (II)$$

worin
$R^4$ und $R^5$ Wasserstoffatome, Alkylgruppen oder aliphatische Acylreste sind und
$R^6$ der Rest eines aromatischen Kohlenwasserstoffs, eines Phenols, Phenolethers, aromatischen Thioethers, einer aromatischen heterocyclischen Verbindung oder eines organischen Säureamids ist, dadurch gekennzeichnet, daß das Diazoniumsalzanion des Polykondensationsprodukts das Anion einer Aminoalkansulfonsäure ist.

2. Polykondensationsprodukt nach Anspruch 1, dadurch gekennzeichnet, daß die Aminoalkansulfonsäure als weitere Substituenten Hydroxy- oder Alkoxygruppen enthält.

3. Verfahren zur Herstellung eines lichtempfindlichen Diazoniumgruppen enthaltenden Polykondensationsprodukts, bei dem man in stark saurem Medium ein Diazoniumsalz der Formel I

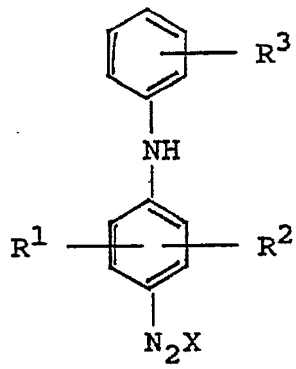

(I)

worin
$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und
X das Anion des Diazoniumsalzes ist,
mit einer Verbindung der Formel II

$$R^4\text{-O-CH}_2\text{-R}^6\text{-CH}_2\text{-O-R}^5 \qquad (II)$$

kondensiert, worin
$R^4$ und $R^5$ Wasserstoffatome, Alkylgruppen oder aliphatische Acylreste sind und
$R^6$ der Rest eines aromatischen Kohlenwasserstoffs, eines Phenols, Phenolethers, aromatischen Thioethers, einer aromatischen heterocyclischen Verbindung oder eines organischen Säureamids ist, dadurch gekennzeichnet, daß das erhaltene Kondensationsprodukt durch Zusatz eines Überschusses einer Aminoalkansulfonsäure oder ihres Alkalisalzes als ein Aminoalkansulfonat isoliert wird.

4. Lichtempfindliches Aufzeichnungsmaterial aus einem Schichtträger und einer lichtempfindlichen Schicht, die als lichtempfindliche Verbindung ein Diazoniumsalz-Polykondensationsprodukt enthält, dadurch gekennzeichnet, daß die Schicht ein Polykondensationsprodukt gemäß Anspruch 1 enthält.

## Claims

1. A light-sensitive polycondensation product containing diazonium groups, obtained from
a) a diazonium salt of the general formula I

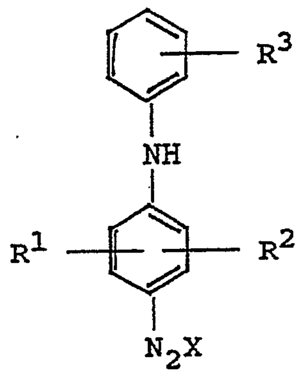

(I)

in which

$R^1$, $R^2$ and $R^3$ are hydrogen atoms, halogen atoms, alkyl groups having 1 to 3 carbon atoms or alkoxy groups having 1 to 6 carbon atoms and

X is the anion of the diazonium salt, and

b) a compound of the general formula II

$$R^4\text{–O–}CH_2\text{–}R^6\text{–}CH_2\text{–O–}R^5 \quad (II)$$

in which

$R^4$ and $R^5$ are hydrogen atoms, alkyl groups or aliphatic acyl radicals and

$R^6$ is the radical of an aromatic hydrocarbon, of a phenol, of a phenol ether, of an aromatic thioether, of an aromatic heterocyclic compound or of an organic acid amide,

characterized in that the diazonium salt anion of the polycondensation product is the anion of an aminoalkanesulfonic acid.

2. A polycondensation product as claimed in claim 1, characterized in that the aminoalkanesulfonic acid contains hydroxy groups or alkoxy groups as further substituents.

3. A process for the preparation of a light-sensitive polycondensation product containing diazonium groups, wherein a diazonium salt of the formula I

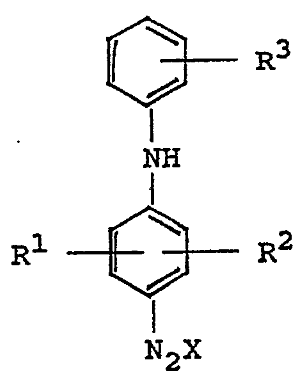

(I)

in which

$R^1$, $R^2$ and $R^3$ are hydrogen atoms, halogen atoms, alkyl groups having 1 to 3 carbon atoms or alkoxy groups having 1 to 6 carbon atoms and

X is the anion of the diazonium salt,

is condensed in a strongly acidic medium with a compound of the formula II

$$R^4\text{–O–}CH_2\text{–}R^6\text{–}CH_2\text{–O–}R^5 \quad (II)$$

in which

$R^4$ and $R^5$ are hydrogen atoms, alkyl groups or aliphatic acyl radicals and

$R^6$ is the radical of an aromatic hydrocarbon, of a phenol, of a phenol ether, of an aromatic thioether, of an aromatic heterocyclic compound or of an organic acid amide,

characterized in that the resulting condensation product is isolated as an aminoalkanesulfonate by adding an excess of an aminoalkanesulfonic acid or an alkali metal salt thereof.

4. A light-sensitive recording material comprised of a layer support and a light-sensitive layer which contains a diazonium salt polycondensation product as the light-sensitive compound, characterized in that the layer contains a polycondensation product as claimed in claim 1.

## Revendications

1. Produit de polycondensation photosensible, contenant des groupes diazonium, obtenu à partir

a) d'un sel de diazonium de formule générale I

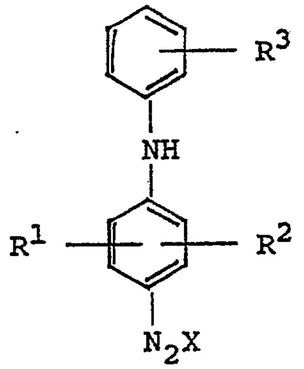

(I)

dans laquelle

$R^1$, $R^2$ et $R^3$ représentent des atomes d'hydrogène ou d'halogène, ou des groupes alkyle ayant de 1 à 3 atomes de carbone, ou des groupes alcoxy ayant de 1 à 6 atomes de carbone, et

X est l'anion du sel de diazonium, et

b) d'un composé de formule générale II

$$R^4-O-CH_2-R^6-CH_2-O-R^5 \qquad (II)$$

dans laquelle

$R^4$ et $R^5$ représentent des atomes d'hydrogène, des groupes alkyle ou des radicaux acyle aliphatiques et

$R^6$ est le reste d'un hydrocarbure aromatique, d'un phénol, éther phénolique, thioéther aromatique, d'un composé hétérocyclique aromatique ou d'un amide organique,

caractérisé en ce que l'anion du sel de diazonium du produit de polycondensation est l'anion d'un acide aminoalcanesulfonique.

2. Produit de polycondensation selon la revendication 1, caractérisé en ce que l'acide aminoalcanesulfonique contient, en tant qu'autres substituants, des groupes hydroxy ou alcoxy.

3. Procédé pour la préparation d'un produit de polycondensation photosensible, contenant des groupes diazonium, dans lequel on condense en milieu fortement acide un sel de diazonium de formule I

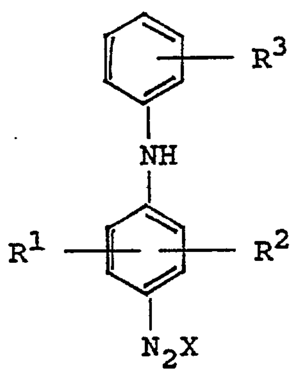

(I)

dans laquelle

$R^1$, $R^2$ et $R^3$ représentent des atomes d'hydrogène ou d'halogène, ou des groupes alkyle ayant de 1 à 3 atomes de carbone, ou des groupes alcoxy ayant de 1 à 6 atomes de carbone, et

X est l'anion du sel de diazonium,

avec un composé de formule générale II

$$R^4-O-CH_2-R^6-CH_2-O-R^5 \qquad (II)$$

dans laquelle

$R^4$ et $R^5$ représentent des atomes d'hydrogène, des groupes alkyle ou des radicaux acyle aliphatiques et

$R^6$ est le reste d'un hydrocarbure aromatique, d'un phénol, éther phénolique, thioéther aromatique, d'un composé hétérocyclique aromatique ou d'un amide organique,

caractérisé en ce que le produit de condensation obtenu est isolé sous forme d'un aminoalcanesulfonate, par addition d'un excès d'un acide aminoalcanesulfonique ou d'un sel alcalin de celui-ci.

4. Matériau de reprographie photosensible constitué d'un support de couche et d'une couche photosensible, un produit de polycondensation de sel de diazonium, caractérisé en ce que la couche contient un produit de polycondensation selon la revendication 1.